# FASCICULE DE BREVET EUROPEEN

(11) **EP 1 327 155 B1**
(45) Date de publication et mention de la délivrance du brevet: **28.01.2009**
(21) Numéro de dépôt: 01978542.7
(22) Date de dépôt: 16.10.2001
(51) Int. Cl.: G01R 31/28

(54) **DISPOSITIF POUR ASSURER LE TEST D'UN APPAREIL ELECTROMECANIQUE ET DES MOYENS POUR UN TEL DISPOSITIF**
ANORDNUNG ZUM TEST IN EINER ELEKTROMECHANISCHEN VORRICHTUNG UND MITTEL FÜR EINE SOLCHE ANORDNUNG
DEVICE FOR TESTING AN ELECTROMECHANICAL APPARATUS AND METHOD FOR DETERMINING MEANS CONSTITUTING SUCH A DEVICE

(30) Priorité: 17.10.2000 FR 0013269
(43) Date de publication de la demande: 16.07.2003
(73) Titulaire: Larisys, 67220 Ville (FR)
(72) Inventeur: MEYER, Patrice, F-68140 Eschbach-au-Val (FR); LANG, Serge, F-68890 Meyenheim (FR); RITZENTHALER, Jean-Michel, F-67920 Sundhouse (FR)
(74) Mandataire: Rhein, Alain
(86) Numéro de dépôt international: PCT/FR2001/003199
(87) Numéro de publication internationale: WO 2002/033431

(56) Documents cités:
- EP-A- 0 050 292
- GB-A- 2 184 555

## Description

La présente invention concerne un dispositif destiné à assurer le test d'un appareil de type électromécanique, notamment une carte électronique. Cette invention concerne, encore, un procédé pour la détermination des moyens aptes à entrer dans la composition d'un dispositif destiné à assurer le test d'un tel appareil de type électromécanique.

Il convient d'observer que la présente invention a trait au domaine de la fabrication d'outils permettant de tester des appareils électromécaniques et/ou leur constituants.

A ce propos, l'on observera que de tels appareils électromécaniques adoptent, par exemple, la forme d'une carte électronique ou intègrent au moins une telle carte qui, de manière connue en soi, comporte au moins un circuit électrique auquel est associé au moins un composant électronique ou analogue.

Aussi, avant d'entamer la production en série ou la commercialisation d'un tel appareil électromécanique, il convient de s'assurer que ce dernier est bien conforme aux attentes du concepteur et/ou du consommateur.

Pour ce faire, il est indispensable de faire subir à cet appareil un certain nombre de tests destinés à vérifier si tous les composants sont présents et fonctionnent de manière appropriée, aussi bien individuellement qu'en interaction les uns avec autres.

Ainsi, l'un de ces tests consiste à contrôler visuellement, au niveau dudit appareil, selon le cas, si tous les composants sont présents, si ce sont effectivement les composants auxquels on s'attend (contrôle de la forme et/ou de la couleur), si ceux-ci fonctionnent de manière appropriée (contrôle de l'émission d'un signal lumineux ou analogue).

La réalisation d'un tel test nécessite de faire appel à des moyens spécifiques aptes à soumettre ledit appareil à un test de type visuel.

Il convient, encore, de s'assurer de l'intégrité des composants implantés au niveau d'une carte électronique d'un appareil électromécanique. Pour ce faire, il est indispensable de recourir à des moyens aptes à soumettre ledit appareil à un test de type in-situ, un tel test consistant, notamment, à vérifier, pour chaque composant, le bon fonctionnement de ce dernier.

On observera, de plus, que les composants d'une telle carte ou d'un tel appareil sont, usuellement, associés à un circuit électrique, notamment par soudure. Aussi, il est habituel de soumettre ledit appareil, par l'intermédiaire de moyens appropriés, à un test de type structurel consistant, notamment, à vérifier l'état de ces soudures et/ou le passage du courant de manière appropriée au travers de ces dernières.

Finalement, il est encore fait appel à des moyens aptes à soumettre ledit appareil à un test de type fonctionnel consistant, notamment, à tester le fonctionnement d'un ensemble de composants constituant un bloc fonctionnel conçu apte à présenter un comportement déterminé, notamment sous l'impulsion d'un stimulus électrique.

A ce propos, il convient d'observer que la réalisation de chacun de ces tests nécessite de faire appel à des moyens spécifiques de sorte que, pour chaque type de test, il a été conçu un testeur spécifique. Chacun de ces testeurs comporte, d'une part, des moyens spécifiques pour la réception dudit appareil électromécanique et, d'autre part, des moyens spécifiques de gestion du test, notamment sous forme d'un moyen de traitement, comme un logiciel, de type propriétaire et/ou fonctionnant sous un langage particulier. Des testeurs spécifiques sont décrits dans EP 0050292, GB 2184555 et dans US4240750.

De plus, ces moyens de réception et/ou ces moyens de gestion sont, usuellement, incompatibles de sorte que, lors d'une campagne de test d'un appareil déterminé, il est indispensable de tester ce dernier sur chacun de ces testeurs de manière séquentielle et indépendante.

Ainsi, la réalisation d'une telle campagne de tests nécessite, de manière impérative, de disposer d'un testeur correspondant à chaque type de test à effectuer ce qui se traduit par une multiplication du nombre de testeurs à acquérir.

De plus, lors d'une telle campagne de tests, il convient d'implanter ledit appareil à tester au niveau de chacun des testeurs ce qui se traduit par une multiplication des manipulations de cet appareil avec les risques de détériorations que cela comporte.

La présente invention permet de pallier aux inconvénients des testeurs connus dans l'état de la technique et concerne, d'une part, un nouveau testeur et, d'autre part, un nouveau procédé d'aide à la conception du modèle d'un tel testeur.

Ainsi, l'invention concerne le dispositif défini par la revendication 1

L'invention concerne, encore, un procédé défini par la revendication 13

Les avantages du dispositif selon l'invention consistent en ce qu'il est possible, à l'aide d'un seul et unique testeur, de procéder à différents types de tests sur un appareil électromécanique. Un tel dispositif possède une unique interface de test destinée à recevoir ledit appareil qui est implanté au niveau du testeur pour toute la durée de la campagne de tests, sans que le passage d'un test à l'autre nécessite une manipulation de cet appareil électromécanique.

En fait, le dispositif de test selon l'invention comporte des moyens aptes à soumettre ledit appareil électromécanique à différents types de tests, de tels moyens étant gérés par l'intermédiaire d'un même moyen de gestion que comporte ce dispositif.

On observera que les moyens de test comportent, notamment, des cartes électroniques de conception nouvelle aptes à être pilotées par un même moyen de gestion, là encore de conception appropriée et nouvelle.

Selon un autre avantage de la présente invention, le dispositif de test autorise une tracabilité de différents tests effectués sur un même appareil ou sur une série d'appareils.

En outre, ledit dispositif de test permet à un seul opérateur d'assurer, à lui seul, une campagne complète de tests sur un même appareil.

L'invention concerne, encore, un procédé pour la détermination des moyens aptes à entrer dans la composition d'un dispositif destiné à assurer le test d'un appareil de type électromécanique.

Un tel procédé permet, à partir des caractéristiques dudit appareil électromécanique, de proposer au moins un scénario de test susceptible de permettre d'assurer le test de cet appareil. Un tel scénario de test nécessite la mise en oeuvre d'un certain nombre de ressources matérielles. Le procédé consiste, encore, à autoriser le choix, en fonction de ces ressources matérielles (disponibles ou à acquérir), du scénario le plus approprié pour la réalisation du test de l'appareil électromécanique. Ledit procédé permet, alors, de définir, automatiquement, le modèle du testeur apte à assurer le test de cet appareil.

Un tel procédé permet, avantageusement, de fournir, par exemple à un ingénieur de test, un outil d'aide à la décision pour le choix d'un testeur particulièrement approprié à l'appareil électromécanique devant être testé.

La présente invention sera mieux comprise à la lecture de la description qui va suivre se rapportant au dessin joint en annexe et dans lequel :
- la figure 1 est une vue schématisée et en élévation d'un dispositif de test selon l'invention ;
- la figure 2 est une représentation schématisée correspondant à une vue en éclaté et en coupe partielle, d'une part, de l'interface de test et, d'autre part, d'une partie des moyens aptes à soumettre un appareil électromécanique à des tests ;

La présente invention concerne le domaine de la conception d'outils destinés à assurer le test d'appareils de type électromécaniques.

Un tel appareil électromécanique se présente, par exemple, sous la forme d'une carte électronique ou, tout du moins, comporte au moins une telle carte électronique. Cette dernière est définie, de manière connue en soi, par au moins un circuit électrique auquel est associé au moins un composant électronique, électro-optique, électromagnétique ou autre.

Si, dans la suite de la description, il sera, plus particulièrement, fait référence à un appareil électromécanique 1 sous la forme d'une carte électronique 2, il est évident que la présente invention n'y est nullement limitée. Ainsi, comme évoqué ci-dessus, un tel appareil peut être de conception plus complexe et adopter, par exemple, la forme d'un combiné de téléphone ou autre.

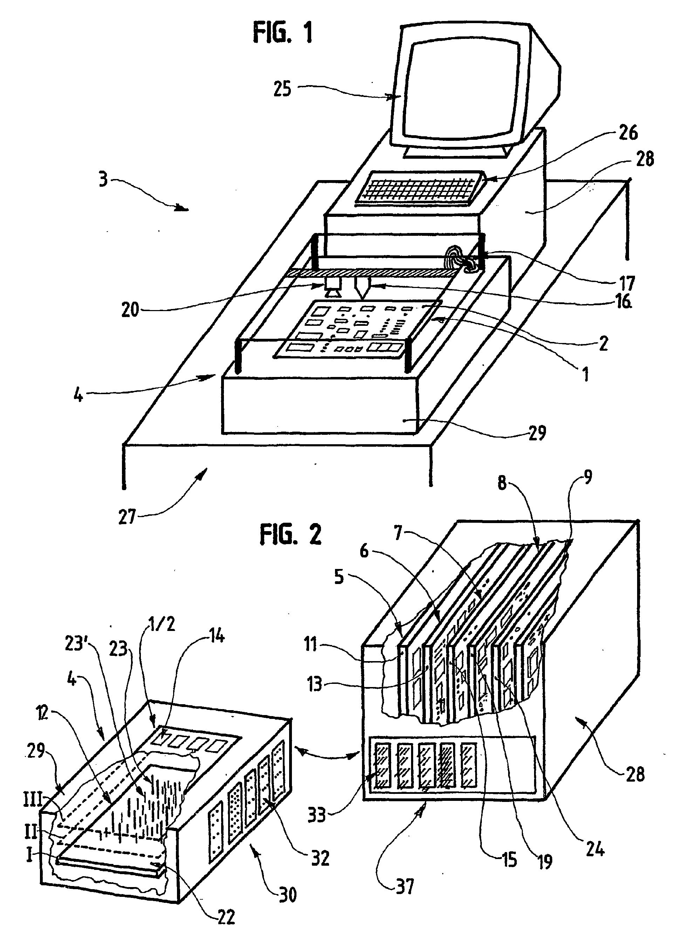

En fait, la présente invention concerne un dispositif 3 représenté, notamment, dans la figure 1 et destiné à assurer le test d'un appareil 1 de type électromécanique tel qu'évoqué ci-dessus.

Un tel dispositif 3 comporte :
- une interface de test 4 unique conçue apte à recevoir ledit appareil électromécanique 1 ;
- des moyens 5 aptes à soumettre ledit appareil 1 à un test de type in-situ ;
- des moyens 6 aptes à soumettre ledit appareil 1 à un test de type fonctionnel ;
- des moyens 7 aptes à soumettre ledit appareil 1 à un test de type structurel ;
- des moyens 8 aptes à soumettre ledit appareil à un test de type visuel ;
- des moyens 9 aptes à assurer la gestion des différents moyens de test in-situ 5, fonctionnel 6, structurel 7 et visuel 8 ;
- des moyens 10 de commande et de pilotage desdits moyens de gestion 9 et/ou des différents moyens de test 5, 6, 7, 8.

En fait et selon une autre caractéristique de l'invention, les moyens 5 aptes à soumettre ledit appareil 1 à un test de type in-situ sont constitués par au moins une carte électronique 11 conçue spécifiquement pour la réalisation de ce type de test.

A ce propos, il convient d'observer qu'une carte électronique 11, entrant dans la composition des moyens 5 aptes à soumettre ledit appareil 1 à un test de type in-situ, présente une conception nouvelle et peut être développée à partir d'une carte électronique standard et multifonctions ayant été modifiée et/ou complétée par des moyens aptes à lui permettre de réaliser des tests in-situ.

Une telle carte électronique spécifique 11 est raccordée, par l'intermédiaire de moyens de raccordement 12 de type électrique, audit appareil électromécanique 1.

En ce qui concerne les moyens 6 aptes à soumettre ledit appareil 1 à un test de type fonctionnel, ceux-ci sont définis, là encore, par au moins une carte électronique 13 conçue spécifiquement pour la réalisation de ce type de test.

Une telle carte électronique 13 est raccordée, par l'intermédiaire de moyens de raccordement 12 de type électrique, audit appareil électromécanique 1.

On observera, là encore, qu'une telle carte électronique 13 peut présenter une conception nouvelle et peut être développée à partir d'une carte électronique standard et multifonctions ayant été modifiée et/ou complétée par des moyens aptes à lui permettre de réaliser des tests fonctionnels.

Cependant et selon un mode de réalisation particulier de la présente invention, une carte électronique 13, correspondant aux moyens 6 aptes à soumettre ledit appareil 1 à un test de type fonctionnel, peut être constituée par une carte électronique 11 similaire à celle entrant dans la composition des moyens 5 aptes à soumettre ledit appareil 1 à un test de type in-situ.

Selon une autre caractéristique de la présente invention, ledit dispositif 3 comporte, encore, des moyens aptes à soumettre ledit appareil électromécanique 1 à un test de type boundary-scan.

De tels moyens sont, là encore, définis par au moins une carte électronique (non représentée) qui, à l'instar des cartes électroniques 11, 13, peut, également, être conçue spécifiquement pour la réalisation de ce type de test, notamment à partir d'une carte électronique standard et multifonction modifiée et/ou complétée.

Cependant et selon un mode de réalisation particulier, une telle carte électronique, correspondant aux moyens de test de type boundary scan, peut être constituée par une carte électronique similaire à celle 11, 13 des moyens de test in-situ et/ou fonctionnel.

Là encore une telle carte électronique est raccordée, par l'intermédiaire de moyens de raccordement 12 de type électrique, audit appareil électromécanique 1.

A ce propos, il convient d'observer qu'un test de type boundary scan nécessite, au niveau dudit appareil 1, la présence d'au moins un composant compatible avec un tel test.

En fait, un tel composant comporte des ports spécifiques et dédiés à un tel type de test. C'est, plus particulièrement, au niveau de ces ports et/ou au niveau d'un bus de test, raccordé à ces ports, que vont être connectés lesdits moyens de raccordement 12.

Selon une autre caractéristique, les moyens 7 aptes à soumettre ledit appareil 1 à un test structurel sont définis, d'une part, par au moins une carte électronique 15 conçue spécifiquement pour la réalisation de ce type de test.

Une fois de plus, on observera qu'une telle carte 15 peut présenter une conception nouvelle et peut être développée à partir d'une carte électronique standard et multifonctions ayant été modifiée et/ou complétée par des moyens aptes à lui permettre de réaliser des tests structurels.

Lesdits moyens 7, aptes à soumettre ledit appareil 1 à un test structurel, sont, d'autre part, définis par au moins une sonde 16 conçue apte à réaliser un couplage capacitif avec au moins un composant électronique 14 dudit appareil électromécanique 1.

Tel que visible sur la figure 1, une telle sonde 16 peut être rendue solidaire de l'interface de test 4 par l'intermédiaire de moyens de solidarisation. Ces derniers peuvent être conçus aptes à assurer un déplacement de ladite sonde 16 par rapport audit appareil 1, ceci de manière à permettre un positionnement de cette sonde 16 au niveau dudit composant 14 qu'il convient de tester.

En fait, un tel déplacement peut être assuré sous l'impulsion desdits moyens de gestion 9 et/ou desdits moyens de commande et de pilotage 10.

Une autre caractéristique consiste en ce qu'une telle carte électronique 15 est raccordée, d'une part, audit appareil électromécanique 1 par l'intermédiaire de moyens de raccordement 12 de type électrique et, d'autre part, auxdites sondes 16 par l'intermédiaire de moyens de liaison 17 de type électrique, notamment filaires.

Un tel raccordement autorise, d'une part, l'émission d'un signal électrique primaire en direction d'une telle sonde 16 et, d'autre part, la réception d'un signal électrique secondaire en provenance d'un composant 14 dudit appareil 1 couplé à cette sonde 16.

Selon une autre caractéristique de l'invention, les moyens 8, aptes à soumettre ledit appareil électromécanique 1 à un test de type visuel, sont définis, d'une part, par au moins une carte électronique 19 d'acquisition d'image et, d'autre part, par au moins une caméra 20 raccordée à ladite carte d'acquisition 19 par l'intermédiaire de moyens de liaison 17 de type électrique, notamment filaires.

Un mode préféré de réalisation consiste à rendre une telle caméra 20 solidaire de ladite interface de test 4 par l'intermédiaire de moyens de solidarisation conçus aptes à assurer un déplacement de ladite caméra 20 par rapport audit appareil 1, ceci de manière à permettre un positionnement de cette caméra 20 au niveau dudit composant 14 qu'il convient de tester.

En fait, un tel déplacement peut être assuré sous l'impulsion desdits moyens de gestion 9 et/ou desdits moyens de commande et de pilotage 10.

Il convient d'observer que de tels moyens 8 permettent, notamment, de s'assurer de la présence d'un composant au niveau de l'appareil 1 à tester.

Ces moyens 8 de test visuel peuvent, encore, être complétés par des moyens aptes à délivrer un signal électrique à l'un au moins des composants 14 dudit appareil 1 qui, sous l'impulsion de ce signal, est susceptible d'émettre un signal visuel, notamment un signal lumineux, un affichage ou autre, destiné à être capté par au moins une caméra 20.

De tels moyens, aptes à délivrer un signal électrique audit appareil 1, peuvent, là encore, être constitués par au moins une carte électronique, d'une part, correspondant, par exemple, à celle d'un moyen de test 5, 6, 7 et, d'autre part, raccordée audit appareil 1 par l'intermédiaire de moyens de liaison et/ou de raccordement de type électrique.

Il convient, de plus, d'observer que lesdits moyens de test in-situ 5 et/ou fonctionnel 6 et/ou structurel 7 et/ou visuel 8 et/ou boundary scan peuvent être complétés par des moyens de type mécaniques, par exemple des doigts de commande de type escamotables, aptes à actionner un bouton, une touche ou analogue que comporte ledit appareil 1 à tester. Un tel actionnement se traduit, dans le cas d'un bon fonctionnement dudit appareil 1, par l'établissement d'un contact électrique, par l'émission d'un signal lumineux, par un affichage spécifique ou autre.

Un tel mode de réalisation trouvera une application particulière lorsqu'il s'agit de tester un appareil comme un téléphone, notamment cellulaire, ceci lors d'un contrôle qualité préalable à son conditionnement final.

Tel qu'évoqué ci-dessus, ledit dispositif 3 de test comporte des moyens de raccordement 12 de type électrique aptes à assurer une liaison électrique entre, d'une part, ledit appareil 1 à tester et, d'autre part, au moins une carte électronique 11, 13, 15.

En fait, comme visible figure 2, de tels moyens de raccordement 12 peuvent comporter au moins un lit 22 à clous 23, 23'. De tels clous 23, 23' sont, d'une part, conçus aptes à établir un contact électrique avec ledit appareil électromécanique 1 et, d'autre part, associés à des moyens de type filaire pour leur raccordement auxdites cartes électroniques 11, 13, 15.

Il convient d'observer qu'un tel lit 22 à clous 23, 23' comporte des moyens aptes à autoriser l'établissement d'un contact électrique entre ledit appareil électromécanique 1 et une partie au moins desdits clous 23 de ce lit 22 à clous 23, 23'.

De tels moyens permettent d'assurer un contact électrique, au niveau dudit appareil 1 à tester, avec une partie seulement des clous 23 d'un tel lit 22 ce qui autorise, par exemple, uniquement le test d'une partie dudit appareil 1 et/ou d'un ou plusieurs composants 14 de ce dernier 1.

Un tel résultat peut être obtenu par l'intermédiaire de moyens, aptes à autoriser l'établissement du contact électrique, définis par des lits 22 à clous 23 et/ou des clous 23, 23' conçus de manière à être au moins en partie escamotables.

Il a été représenté figure 2 un lit 22 à clous 23 de type escamotable et susceptible d'adopter différentes positions (I, II, III) par rapport audit appareil 1.

Sur cette même figure, on observera que les clous 23, 23' de ce lit 22 présentent au moins deux longueurs différentes sachant qu'au moins les clous 23 les plus longs sont conçus aptes à être escamotés.

En fait, ces clous 23 sont rendus solidaires dudit lit 22 par l'intermédiaire de moyens autorisant un mouvement par rapport à ce lit 22, notamment de manière perpendiculaire au plan de ce dernier, et ceci selon une certaine course. Les clous 23, 23' de différente longueur peuvent, par conséquent, présenter une course différente.

Un tel lit 22 à clous 23 peut être complété par des moyens aptes à assurer son positionnement par rapport audit appareil 1 à tester, de tels moyens pouvant, par exemple, être actionnés manuellement et/ou par l'intermédiaire des moyens 5, 6, 7, 8 aptes à soumettre ledit appareil à un type test.

Sous l'impulsion de ces moyens de positionnement, ce lit 22 peut adopter différentes positions, notamment trois positions (I, II, III) comme visible sur la figure 2.

Ainsi, dans la position I, correspondant à la position la plus éloignée dudit lit 22 par rapport audit appareil 1, aucun clou 23, 23' n'est en contact avec ce dernier.

Dans la position II, seuls les clous 23 de plus grande longueur sont en contact avec ledit appareil 1 à tester. Dans cette configuration, il est, par exemple, possible de réaliser un test de type fonctionnel dudit appareil 1.

Dans la position III dudit lit 22, tous les clous 23, 23' sont en contact avec ledit appareil à tester, les clous 23 de plus grande longueur sont, alors, rétractés. Dans cette configuration, il est, par exemple, possible de réaliser un test de type in-situ dudit appareil 1.

Selon une autre caractéristique de l'invention, ledit dispositif 3 comporte des moyens 9 aptes à assurer la gestion des différents moyens de test in-situ 5, fonctionnel 6, structurel 7, visuel 8 et boundary scan.

En fait, de tels moyens de gestion 9 peuvent être constitués par un micro-ordinateur ou au moins une carte électronique 24, de type PC ou autre, raccordé aux cartes électroniques 11, 13, 15, 19 desdits moyens de test 5, 6, 7, 8.

A ce propos, il convient d'observer que les cartes électroniques 11, 13, 15, 19 sont susceptibles de fonctionner sous un langage spécifique. Lesdits moyens de gestion 9 sont, alors, conçus aptes à communiquer avec ces cartes électroniques 11, 13, 15, 19 dans leur propre langage, notamment en faisant appel à des bibliothèques de programmes que comportent ces moyens de gestion 9.

Il convient, de plus, d'observer que les moyens 10 de commande et de pilotage desdits moyens de gestion 9 et/ou des différents moyens de test 5, 6, 7, 8 sont définis par une interface homme-machine comportant, notamment, un écran de visualisation 25 ainsi que des moyens de saisie tel qu'un clavier 26 et/ou un pupitre de commande.

En fait, tel que visible sur la figure 1, le dispositif 3 selon l'invention adopte la forme d'un châssis 27, notamment une plateforme ou une baie de test.

Ce châssis 27 comporte un rack 28 destiné à recevoir lesdites cartes électroniques 11, 13, 15, 19, 24 correspondant, notamment, aux moyens de test 5, 6, 7, 8 et/ou aux moyens 9 de gestion de ces derniers.

Ledit châssis 27 est, encore, conçu apte à recevoir ladite interface de test 4, cette dernière adoptant la forme d'un boîtier amovible 29 pourvu de moyens de connexion 30 aptes à coopérer avec des moyens de connexion complémentaires 31 associés audit rack 28.

A ce propos, on observera que ces moyens de connexion 30 peuvent être définis par au moins un bloc de connexion 32, selon le cas de type mâle ou femelle, implanté au niveau du boîtier 29 de l'interface de test 4. Les moyens de connexion complémentaires 31 sont, alors, constitués par un bloc de connexion complémentaire 33, selon le cas de type femelle ou mâle et de forme complémentaire, implanté au niveau dudit rack 28.

A ce propos, il convient d'observer que, selon un mode de réalisation préféré, chaque bloc de connexion 32, 33 est associé à un type particulier de signal électrique à véhiculer (haute tension, basse tension, haute fréquence, basse fréquence, fort courant, puissance, vidéo...).

Chacun de ces blocs 32, 33 peut, alors, être raccordé à des moyens spécifiques, aptes à délivrer un tel type de signal, et que comporte ledit dispositif 3, notamment au niveau de son châssis 27 ou de son rack 28.

On observera que de tels moyens spécifiques sont associés auxdits moyens de gestion 9 et/ou aux moyens 5, 6, 7, 8 aptes à soumettre ledit appareil 1 à un test, notamment à une carte électronique 11, 13, 15, 19, 24 de ces moyens 5, 6, 7, 8, 9. Un tel mode de réalisation permet, par exemple, de commander ces moyens spécifiques pour leur faire envoyer un signal électrique déterminé audit appareil électromécanique 1.

De plus, lesdits blocs de connexion 32, 33 peuvent être directement associés auxdits moyens de gestion 9 et/ou aux moyens 5, 6, 7, 8 aptes à soumettre ledit appareil 1 à un test (notamment à une carte électronique 11, 13, 15, 19, 24), ceci, notamment, en vue de recueillir un signal électrique en provenance dudit appareil électromécanique 1.

En fait, ces blocs de connexion 32, 33 peuvent présenter des organes de connexion spécifiques conçus aptes à tenir compte de la nature des signaux électriques véhiculés.

En outre, il est possible de concevoir un bloc de connexion déterminé 32, 33 au niveau duquel transitent tous les signaux électriques d'un même type. Tous les signaux électriques d'un même type peuvent alors transiter par un seul et unique bloc de connexion déterminé 32, 33.

De plus, il convient d'observer que les différents types de tests peuvent faire appel à différents moyens spécifiques aptes à délivrer un type déterminé de signal. Aussi, en fonction des moyens spécifiques nécessaires pour mettre en oeuvre tel ou tel type de test, il est possible d'équiper ledit dispositif 3 de blocs de connexion 32, 33 appropriés et susceptibles de véhiculer un type de signal déterminé correspondant à ces moyens spécifiques.

Un tel mode de réalisation permet de conférer aux moyens de connexion 30 et aux moyens de connexion complémentaires 31, une structure de tête de test modulaire.

La présente invention concerne, encore, un procédé pour l'élaboration d'un modèle de testeur destiné à assurer le test d'un appareil électromécanique.

En fait, cette invention concerne, plus particulièrement, un procédé pour la détermination des moyens aptes à entrer dans la composition d'un dispositif 3 de test tel que décrit ci-dessus, et destiné à assurer le test d'un appareil électromécanique 1, par exemple une carte électronique ou autre.

Un tel procédé consiste en ce que :
- l'on autorise une saisie, par l'intermédiaire de moyens de saisie, d'informations concernant les caractéristiques mécaniques, topologiques et/ou électroniques dudit appareil électromécanique ;
- l'on assure, par l'intermédiaire de moyens d'enregistrement, un enregistrement de ces informations dans une mémoire ;
- l'on procède à une sélection, en fonction des informations enregistrées caractéristiques dudit appareil électromécanique et parmi une pluralité de scénarios de test figurant dans des moyens mémoire, d'au moins un scénario de test susceptible d'être appliqué audit appareil électromécanique ;
- l'on associe, à chaque scénario de test sélectionné, l'ensemble des ressources matérielles nécessaires pour la mise en oeuvre de ces scénarios de test ;
- l'on assure, par l'intermédiaire de moyens d'affichage, un affichage du ou des scénarios de test sélectionnés et/ou des ressources matérielles nécessaires à la mise en oeuvre de ces derniers ;
- l'on définit, pour l'un au moins de ces scénarios de test, d'une part, au moins une architecture de testeur intégrant lesdites ressources matérielles nécessaires et correspondant audit scénario de test et, d'autre part, au moins un ensemble d'instructions de test destinées à être appliquées par ce testeur audit appareil électromécanique, l'architecture de ce testeur ainsi que l'ensemble des instructions étant aptes à mettre en oeuvre ce ou ces scénarios de test et constituant un modèle de testeur.

Un tel procédé permet, par conséquent, de modéliser, au moins en partie, un ou plusieurs dispositifs 3 aptes à réaliser le test d'un appareil électromécanique 1 déterminé, une telle modélisation permettant de connaître les ressources matérielles nécessaires à la réalisation d'un tel test ou d'une campagne de tests.

Il convient d'observer que lesdites ressources matérielles correspondent, notamment, à des moyens 5, 6, 7, 8 aptes à soumettre ledit appareil 1 à un test de type in-situ, fonctionnel, structurel, visuel et/ou boundary scan tels qu'évoqués ci-dessus. Ces ressources matérielles peuvent encore correspondre à des moyens spécifiques aptes à délivrer un signal électrique de type déterminé.

Selon une autre caractéristique de l'invention, ce procédé consiste, encore, en ce que :
- lorsque l'on assure l'affichage du ou des scénarios de test sélectionnés et/ou des ressources matérielles correspondantes, l'on autorise, en fonction de ces dernières et par l'intermédiaire de moyens de sélection, la sélection de l'un au moins de ces scénarios de test ;
- ensuite, l'on définit, en fonction du ou des scénarios de test sélectionnés, d'une part, au moins une architecture de testeur intégrant lesdites ressources matérielles nécessaires et correspondant audit scénario de test sélectionné et, d'autre part, au moins un ensemble d'instructions de test destinées à être appliquées par ce testeur audit appareil électromécanique.

Ainsi et de manière avantageuse, le procédé selon l'invention permet, non seulement de déterminer les ressources matérielles nécessaires à la réalisation de différentes campagnes de test sur un même appareil 1, mais également de choisir, en fonction de ressources matérielles disponibles ou à acquérir, le modèle de testeur le plus approprié.

Selon une autre caractéristique de la présente invention, l'on définit un modèle fonctionnel dudit appareil électromécanique 1, ceci à partir des informations correspondant aux caractéristiques mécaniques et/ou électroniques dudit appareil électromécanique 1.

En fait, la définition d'un tel modèle fonctionnel consiste en une décomposition de cet appareil 1 en un ou plusieurs ensembles de blocs fonctionnels interconnectés, un tel bloc étant constitué par un ou plusieurs composants 14 électroniques, électro-optiques, électromagnétiques ou autre.

A ce propos, on observera que certains de ces blocs fonctionnels peuvent, d'ores et déjà, être connus ainsi que les scénarios de test et/ou les ressources matérielles de test qui y correspondent.

Aussi, il est possible de faire appel à une bibliothèque relative à des solutions de test et ayant, au préalable, été enregistrée, notamment, au niveau desdits moyens mémoire.

Une telle bibliothèque peut, de plus, être complétée au fur et à mesure de la modélisation et du test de nouveaux blocs fonctionnels.

Le procédé selon l'invention consiste, encore, en ce que l'on détermine, pour chaque bloc fonctionnel, au moins un ensemble d'instructions de test aptes à être appliquées à ce bloc fonctionnel. L'on détermine, également, au moins une architecture de testeur apte à assurer le test d'un tel bloc fonctionnel.

L'on procède, par l'intermédiaire de moyens de sélection appropriés, à la sélection de l'un au moins de ces ensembles d'instructions et/ou de l'une au moins de ces architectures de testeur.

Selon une autre caractéristique de l'invention, le procédé consiste, encore, en ce qu'après avoir saisi les informations relatives aux caractéristiques dudit appareil électromécanique, l'on autorise la saisie d'au moins une information concernant une contrainte qualimétrique que le scénario de test doit respecter.

En fait, une telle contrainte qualimétrique est, par exemple, relative à un coût maximal du test, à un choix restreint de ressources matérielles (choix déterminé par rapport des ressources disponibles), à un nombre limité d'opérateurs et/ou d'opérations...

A ce propos, on observera que le procédé selon l'invention permet, encore, de faire appel à des moyens statistiques aptes à fournir, en fonction de certaines contraintes qualimétriques déterminées, des données statistiques qualifiant un ou plusieurs scénarios de test.

Finalement, il convient d'observer que ledit procédé décrit ci-dessus est, au moins en partie, susceptible d'être mis en oeuvre par au moins un moyen de traitement approprié, notamment un logiciel.

En fait, ce procédé constitue, avantageusement, un outil apte à assurer une assistance automatique à un ingénieur en charge du test d'un appareil électromécanique, notamment une carte électronique, ceci dans une démarche de l'ingénieur consistant à élaborer une solution de test.

## Revendications

1. Dispositif destiné à assurer le test d'un appareil de type électromécanique (1) comportant un circuit électrique ainsi qu'au moins un composant électronique (14), le dispositif comportant
- une interface de test (4) unique conçue apte à recevoir ledit appareil électromécanique (1) ;
- des moyens (5) aptes à soumettre ledit appareil (1) à un test de type in-situ ;
- des moyens (6) aptes à soumettre ledit appareil (1) à un test de type fonctionnel ;
- des moyens (7) aptes à soumettre ledit appareil (1) à un test de type structurel ;
- des moyens (8) aptes à soumettre ledit appareil (1) à un test de type visuel ;
- des moyens (9) aptes à assurer la gestion des différents moyens (5, 6, 7, 8) de test in-situ, fonctionnel, structurel et visuel ;
- des moyens (10) de commande et de pilotage desdits moyens de gestion (9) et/ou des différents moyens de test (5, 6, 7, 8),
**caractérisé en ce que**
- l'appareil de type électromécanique (1) est une carte électronique (2),
- les moyens (7) aptes à soumettre ledit appareil électromécanique (1) à un test de type structurel comprennent au moins une sonde (16) rendue solidaire de l'interface de test (4) et apte à réaliser un couplage capacitif avec au moins un composant électronique (14) dudit appareil électromécanique (1) et
- les moyens (8) aptes à soumettre ledit appareil électromécanique (1) à un test de type visuel comprennent au moins une caméra (20) rendue solidaire de ladite interface de test (4).

2. Dispositif selon la revendication 1, **caractérisé en ce que** les moyens (5) aptes à soumettre ledit appareil électromécanique (1) à un test de type in-situ sont définis par au moins une carte électronique spécifique (11) raccordée, par l'intermédiaire de moyens de raccordement (12) de type électrique, audit appareil électromécanique (1).

3. Dispositif selon l'une quelconque des revendications précédentes, **caractérisé en ce que** les moyens (6) aptes à soumettre ledit appareil électromécanique (1) à un test de type fonctionnel sont définis par au moins une carte électronique spécifique (13) raccordée, par l'intermédiaire de moyens de raccordement (12) de type électrique, audit appareil électromécanique (1).

4. Dispositif selon l'une quelconque des revendications précédentes, **caractérisé en ce que** les moyens (7) aptes à soumettre ledit appareil électromécanique (1) à un test de type structurel sont définis, d'une part, par au moins une carte électronique spécifique (15) et, d'autre part, par l'au moins une sonde (16) rendue solidaire de l'interface de test (4) et apte à réaliser un couplage capacitif avec au moins un composant électronique (14) dudit appareil électromécanique (1), cette carte électronique (15) étant raccordée, d'une part, auxdites sondes (16) par l'intermédiaire de moyens de liaison (17) de type électrique et, d'autre part, audit appareil électromécanique (1) par l'intermédiaire de moyens de raccordement (12) de type électrique.

5. Dispositif selon l'une quelconque des revendications précédentes, **caractérisé en ce qu'**il comporte des moyens aptes à soumettre ledit appareil (1) à un test de type boundary scan, de tels moyens étant définis par au moins une carte électronique spécifique raccordée, par l'intermédiaire de moyens de raccordement (12) de type électrique, audit appareil électromécanique (1).

6. Dispositif selon l'une quelconque des revendications précédentes, **caractérisé en ce que** les moyens (8) aptes à soumettre ledit appareil électromécanique (1) à un test de type visuel sont définis, d'une part, par au moins une carte électronique (19) d'acquisition d'image et, d'autre part, par l'au moins une caméra (20) rendue solidaire de ladite interface (4) et raccordée, par l'intermédiaire de moyens de liaison (17) de type électrique, à ladite carte d'acquisition (19).

7. Dispositif selon l'une quelconque des revendications 2 à 5, **caractérisé en ce que** les moyens de raccordement (12) de type électrique comportent au moins un lit (22) à clous (23, 23'), ces clous (23) étant, d'une part, conçus aptes à établir un contact électrique avec ledit appareil électromécanique (1) et, d'autre part, associés à des moyens de type filaire pour leur raccordement auxdites cartes électroniques.

8. Dispositif selon la revendication 7, **caractérisé par le fait que** le lit (22) à clous (23) comporte des moyens aptes à autoriser l'établissement d'un contact électrique entre ledit appareil électromécanique (1) et une partie (23) au moins desdits clous (23, 23') de ce lit (22) à clous.

9. Dispositif selon la revendication 8, **caractérisé par le fait que** les moyens aptes à autoriser l'établissement du contact électrique sont définis par des lits (22) à clous (23, 23') et/ou des clous (23, 23') conçus de manière à être au moins en partie escamotables.

10. Dispositif selon les revendications 2 à 6, **caractérisé en ce que** les moyens de gestion (9) sont constitués par un micro-ordinateur ou une carte électronique (24), de type PC ou autre, raccordé aux cartes électroniques (11, 13, 15, 19) desdits moyens de test (5, 6, 7, 8).

11. Dispositif selon l'une quelconque des revendications précédentes, **caractérisé en ce que** les moyens (10) de commande et de pilotage desdits moyens de gestion (9) et/ou des différents moyens de test (5, 6, 7, 8) sont définis par une interface homme-machine.

12. Dispositif selon les revendications 2 à 6 et 10, **caractérisé en ce qu'**il adopte la forme d'un châssis (27), d'une part, comportant un rack (28) destiné à recevoir lesdites cartes électroniques (11, 13, 15, 19, 24) correspondant, notamment, aux moyens de test (5, 6, 7, 8) et, d'autre part, recevant ladite interface de test (4), cette dernière (4) adoptant la forme d'un boîtier amovible (29) pourvu de moyens de connexion (30) aptes à coopérer avec des moyens de connexion complémentaires (31) associés audit rack (28).

13. Procédé pour la détermination des moyens aptes à entrer dans la composition d'un dispositif selon l'une quelconque des revendications 1 à 12 et destiné à assurer le test d'un appareil de type électromécanique (1), notamment une carte électronique, **caractérisé en ce que** :
- l'on autorise une saisie, par l'intermédiaire de moyens de saisie, d'informations concernant les caractéristiques mécaniques, topologiques et/ou électroniques dudit appareil électromécanique ;
- l'on assure, par l'intermédiaire de moyens d'enregistrement, un enregistrement de ces informations dans une mémoire ;
- l'on procède à une sélection, en fonction des informations enregistrées caractéristiques dudit appareil électromécanique et parmi une pluralité de scénarios de test figurant dans des moyens mémoire, d'au moins un scénario de test susceptible d'être appliqué audit appareil électromécanique ;
- l'on associe, à chaque scénario de test sélectionné, l'ensemble des ressources matérielles nécessaires pour la mise en oeuvre de ces scénarios de test ;
- l'on assure, par l'intermédiaire de moyens d'affichage, un affichage, du ou des scénarios de test sélectionnés et/ou des ressources matérielles nécessaires à la mise en oeuvre de ces derniers ;
- l'on définit, pour l'un au moins de ces scénarios de test, d'une part, au moins une architecture de testeur intégrant lesdites ressources matérielles nécessaires et correspondant audit scénario de test et, d'autre part, au moins un ensemble d'instructions de test destinées à être appliquées par ce testeur audit appareil électromécanique, l'architecture de ce testeur ainsi que l'ensemble des instructions étant aptes à mettre en oeuvre ce ou ces scénarios de test et constituant un modèle de testeur;
ledit Procédé est, au moins en partie, mis en oeuvre par un logiciel.

14. Procédé selon la revendication 13, **caractérisé en ce que** :
- lorsque l'on assure l'affichage du ou des scénarios de test sélectionnés et/ou des ressources matérielles correspondantes, l'on autorise, en fonction de ces dernières et par l'intermédiaire de moyens de sélection, la sélection de l'un au moins de ces scénarios de test ;
- ensuite, l'on définit, en fonction du ou des scénarios de test sélectionnés, d'une part, au moins une architecture de testeur intégrant lesdites ressources matérielles nécessaires et correspondant audit scénario de test sélectionné et, d'autre part, au moins un ensemble d'instructions de test destinées à être appliquées par ce testeur audit appareil électromécanique.

15. Procédé selon l'une quelconque des revendications 13 ou 14, **caractérisé en ce que**, à partir des informations correspondant aux caractéristiques mécaniques et/ou électroniques dudit appareil électromécanique, l'on définit un modèle fonctionnel de ce dernier consistant en une décomposition de celui-ci en au moins un ensemble de blocs fonctionnels interconnectés.

16. Procédé selon la revendication 15, **caractérisé en ce que** l'on détermine, pour chaque bloc fonctionnel, d'une part, au moins un ensemble d'instructions de test aptes à être appliquées à ce bloc fonctionnel et, d'autre part, au moins une architecture de testeur apte à assurer le test d'un tel bloc fonctionnel.

17. Procédé selon l'une quelconque des revendications 13 à 16, **caractérisé en ce qu'**après avoir saisi les informations relatives aux caractéristiques dudit appareil électromécanique, l'on autorise la saisie d'au moins une information concernant une contrainte qualimétrique que le scénario de test doit respecter.

## Claims

1. Device designed for ensuring the test of an electromechanical apparatus (1) including an electric circuit as well as at least one electronic component (14), the device including:
- one single test interface (4) designed capable of receiving said electromechanical apparatus (1) ;
- means (5) capable of subjecting said apparatus (1) to an on-site test ;
- means (6) capable of subjecting said device (1) to a functional test ;
- means (7) capable of subjecting said device (1) to a structural test ;
- means (8) capable of subjecting said device (1) to a visual test;
- means (9) capable of ensuring the management of the various on-site, functional, structural and visual test means (5, 6, 7, 8) ;
- means (10) for controlling and driving said management means (9) and/or the various test means (5, 6, 7, 8),
wherein
- the electromechanical apparatus (1) is an electronic card (2),
- the means (7) capable of subjecting said electromechanical device (1) to a structural test include at least one probe (16) made integral with the test interface (4) and capable of bringing about a capacitive coupling with at least one electronic component (14) of said electromechanical device (1), and
- the means (8) capable of subjecting said electromechanical device (1) to a visual test include at least one camera (20) made integral with said test interface (4).

2. Device according to claim 1, wherein the means (5) capable of subjecting said electromechanical apparatus (1) to an on-site test are formed by at least one specific electronic card (11) connected through electric connecting means (12) to said electromechanical apparatus (1).

3. Device according to any of the preceding claims, wherein the means (6) capable of subjecting said electromechanical apparatus (1) to a functional test are formed by at least one specific electronic card (13) connected through electric connecting means (12) to said electromechanical apparatus (1).

4. Device according to any of the preceding claims, wherein the means (7) capable of subjecting said device (1) to a structural test are formed, on the one hand, by at least one specific electronic card (15) and, on the other hand, by the at least one probe (16) made integral with the test interface (4) and capable of of performing a capacitive coupling with at least one electronic component (14) of said electromechanical apparatus (1), this electronic card (15) being connected, on the one hand, to said probes (16) through electric connecting means (17), and, on the other hand, to said electromechanical apparatus (1) through electric connecting means (12).

5. Device according to any of the preceding claims, wherein the device includes means capable of subjecting said apparatus (1) to a boundary scan test, such means being formed by at least one specific electronic card connected through electric connecting means (12) to said electromechanical apparatus (1).

6. Device according to any of the preceding claims, wherein the means (8) capable of subjecting said electromechanical apparatus (1) to a visual test are formed, on the one hand, by at least one electronic image-grabber card (19) and, on the other hand, by the at least one camera (20) made integral with said interface (4) and connected through electric connecting means (17) to said image-grabber card (19).

7. Device according to any of claims 2 to 5, wherein the electric connecting means (12) include at least one wiring board (22) with pins (23, 23'), these pins (23) being, one the one hand, designed capable of bringing about an electric contact with said electromechanical apparatus (1) and, on the other hand, associated with wire means for their connection to said electronic card.

8. Device according to claim 7, wherein the wiring board (22) with pins (23) includes means capable of permitting to bring about an electric contact between said electromechanical apparatus (1) and at least part (23) of said pins (23, 23') of this wiring board (22).

9. Device according to claim 8, wherein the means capable of bringing about the electric contact are formed by wiring boards (22) with pins (23, 23') and/or pins (23, 23') designed so as to be at least partially withdrawable.

10. Device according to claims 2 to 6, wherein the management means (9) are formed by a microprocessor or an electronic card (24) of the PC type or similar, connected to the electronic cards (11, 13, 15, 19) of said test means (5, 6, 7, 8).

11. Device according to any of the preceding claims, wherein the means (10) for controlling and driving said management means (9) and/or the various test means (5, 6, 7, 8) are formed by a man-machine interface.

12. Device according to claims 2 to 6 and 10, wherein the device adopts the form of a frame (27) including, on the one hand, a rack (28) designed to receive said electronic cards (11, 13, 15, 19, 24) corresponding namely to the test means (5, 6, 7, 8) and receiving, on the other hand, said test interface (4), the latter (4) adopting the form of a removable case (29) provided with connecting means (30) capable of cooperating with complementary connecting means (31) associated with said rack (28).

13. Method for determining means capable of entering into the composition of a device according to any of the claims 1 to 12 and designed to ensure the test of an electromechanical apparatus (1), namely an electronic card, the method including :
- permitting to acquire, through data-acquisition means, information about the mechanical, topological and/or electronic characteristics of said electromechanical apparatus ;
- ensuring, through recording means, the storing of this information in a memory ;
- proceeding, depending on the stored information, to select characteristics of said electromechanical apparatus and to select from a plurality of test scenarios contained in memory means at least one test scenario likely to be applied to said electromechanical apparatus;
- associating to each selected test scenario all the material resources necessary for implementing these test scenarios ;
- ensuring, through display means, a display of the selected scenario or scenarios and/or of the material resources necessary for implementing the latter ;
- defining, for at least one of these test scenarios, on the one hand, at least one tester architecture integrating said necessary material resources corresponding to said test scenario and, on the other hand, at least one set of test instructions aimed at being applied by this tester to said electromechanical apparatus, the architecture of this tester as well as set of instructions being capable of implementing this or these test scenarios and forming a tester model, said method being implemented at least partially by software.

14. Method according to claim 13, wherein :
- when the display of the selected test scenario or scenarios and/or the corresponding material resources is ensured, the selection of at least one of these test scenarios is permitted as a function of the latter and through selection means;
- then, as a function of the selected test scenario or scenarios are defined, on the one hand, at least one tester architecture integrating said necessary material resources corresponding to the selected test scenario and, on the other hand, at least one set of instructions aimed at being applied by this tester to said electromechanical apparatus.

15. Method acording to any of claims 13 or 14, wherein based on the information corresponding to the mechanical and/or electronic characteristics of said electromechanical apparatus is defined a functional model of the latter consisting of a splitting of same into at least a set of interconnected functional blocks.

16. Method according to claim 15, wherein for each functional block are defined, on the one hand, at least one set of test instructions capable of being applied to this functional block and, on the other hand, at least one tester architecture capable of ensuring the test of such a functional block.

17. Method according to any of claims 13 to 16, wherein after having acquired the information regarding the characteristics of said electromechanical apparatus is permitted the acquisition of at least one information regarding a qualimetric constraint the test scenario has to comply with.

## Patentansprüche

1. Vorrichtung, vorgesehen, um das Testen eines elektromechanischen Geräts (1), umfassend einen Stromkreis sowie zumindest einen elektronischen Bestandteil (14), sicherzustellen, wobei die Vorrichtung folgendes umfasst:
- eine einzige Testschnittstelle (4), die geeignet vorgesehen ist, um das besagte elektromechanische Gerät (1) aufzunehmen;
- Mittel (5), die geeignet sind, um das besagte Gerät (1) einem in-situ Test zu unterziehen;
- Mittel (6), die geeignet sind, um das besagte Gerät (1) einem Funktionaltest zu unterziehen;
- Mittel (7), die geeignet sind, um das besagte Gerät (1) einem strukturellen Test zu unterziehen;
- Mittel (8), die geeignet sind, um das besagte Gerät (1) einem visuellen Test zu unterziehen;
- Mittel (9), die geeignet sind, um die Steuerung der verschiedenen in-situ, funktionalen, strukturellen und visuellen Testmittel (5, 6, 7, 8) zu sichern;
- Mittel (10) zur Kontrolle und zum Betreiben der besagten Steuermittel (9) und/oder der verschiedenen Testmittel (5, 6, 7, 8),
**dadurch gekennzeichnet, dass**
- das elektromechanische Gerät (1) eine elektronische Karte (2) ist,
- die Mittel (7), die geeignet sind, um das besagte elektromechanische Gerät (1) einem strukturellen Test zu unterziehen, wenigstens eine Sonde (16) umfassen, die mit der Testschnittstelle (4) fest verbunden ist und die geeignet ist, um eine kapazitive Kopplung mit wenigstens einem elektronischen Bestandteil (14) des besagten elektromechanischen Geräts (1) zustande kommen zu lassen, und
- die Mittel (8), die geeignet sind, um das besagte elektromechanische Gerät (1) einem visuellen Test zu unterziehen, wenigstens eine Kamera (20) umfassen, die mit der besagten Testschnittstelle (4) fest verbunden ist.

2. Vorrichtung nach Anspruch 1, **dadurch gekennzeichnet, dass** die Mittel (5), die geeignet sind, um das besagte elektromechanische Gerät (1) einem in-situ Test zu unterziehen, durch zumindest eine spezifische elektronische Karte (11) gebildet sind, die über elektrische Anschlussmittel (12) mit dem besagten elektromechanischen Gerät (1) verbunden ist.

3. Vorrichtung nach irgendeinem der vorgehenden Ansprüche, **dadurch gekennzeichnet, dass** die Mittel (6), die geeignet sind, um das besagte elektromechanische Gerät (1) einem funktionalen Test zu unterziehen, durch zumindest eine spezifische elektronische Karte (13) gebildet sind, die über elektrische Anschlussmittel (12) mit dem besagten elektromechanischen Gerät (1) verbunden ist.

4. Vorrichtung nach irgendeinem der vorgehenden Ansprüche, **dadurch gekennzeichnet, dass** die Mittel (7), die geeignet sind, um das besagte elektromechanische Gerät (1) einem strukturellen Test zu unterziehen, einerseits, durch zumindest eine spezifische elektronische Karte (15), und, andererseits, durch die zumindest eine Sonde (16) gebildet sind, die mit der Testschnittstelle (4) fest verbunden ist und die geeignet ist, um eine kapazitive Kopplung mit wenigstens einem elektronischen Bestandteil (14) des besagten elektromechanischen Geräts (1) zustande kommen zu lassen, wobei diese elektronische Karte (15), einerseits, mit den besagten Sonden (16) über elektrische Verbindungsmittel (17), und, andererseits, mit dem besagten elektromechanischen Gerät (1) über elektrische Anschlussmittel (12) verbunden sei.

5. Vorrichtung nach irgendeinem der vorgehenden Ansprüche, **dadurch gekennzeichnet, dass** sie Mittel umfasst, die geeignet sind, um das besagte Gerät (1) einem Boundary Scan Test zu unterziehen, wobei solche Mittel durch zumindest eine spezifische elektronische Karte gebildet seien, die über elektrische Anschlussmittel (12) mit dem besagten elektromechanischen Gerät (1) verbunden ist.

6. Vorrichtung nach irgendeinem der vorgehenden Ansprüche, **dadurch gekennzeichnet, dass** die Mittel (8), die geeignet sind, um das besagte elektromechanische Gerät (1) einem visuellen Test zu unterziehen, einerseits, durch zumindest eine elektronische Bildfangskarte (19), und, andererseits, durch die zumindest eine Kamera (20), die mit der besagten Schnittstelle (4) fest verbunden ist und über elektrische Verbindungsmittel (17) mit der besagten Bildfangskarte (19) verbunden ist, gebildet sind.

7. Vorrichtung nach irgendeinem der Ansprüche 2 bis 5, **dadurch gekennzeichnet, dass** die elektrischen Anschlussmittel (12) zumindest ein Verdrahtungsbrett (22) mit Stiften (23, 23') umfassen, wobei diese Stifte (23), einerseits, geeignet vorgesehen seien, um einen elektrischen Kontakt mit dem besagten elektromechanischen Gerät (1) herzustellen, und, andererseits, Drahtmitteln zugeordnet seien für ihre Verbindung mit den besagten elektronischen Karten.

8. Vorrichtung nach Anspruch 7, **dadurch gekennzeichnet, dass** das Verdrahtungsbrett (22) mit Stiften (23) Mittel umfasst, die geeignet sind, um die Herstellung eines elektrischen Kontakts zwischen dem besagten elektromechanischen Gerät (1) und wenigstens einem Teil (23) der besagten Stifte (23, 23') dieses Verdrahtungsbretts (22) zu erlauben.

9. Vorrichtung nach Anspruch 8, **dadurch gekennzeichnet, dass** die Mittel, die geeignet sind, um die Herstellung des elektrischen Kontakts zu erlauben, durch Verdrahtungsbretter (22) mit Stiften (23, 23') und/oder Stifte (23, 23') gebildet sind, die derart vorgesehen sind, um wenigstens zum Teil einziehbar zu sein.

10. Vorrichtung nach den Ansprüchen 2 bis 6, **dadurch gekennzeichnet, dass** die Steuermittel (9) durch einen Mikroprozessor oder eine elektronische Karte (24) der Art PC oder dergleichen gebildet sind, der/die mit den elektronischen Karten (11, 13, 15, 19) der besagten Testmittel (5, 6, 7, 8) verbunden ist.

11. Vorrichtung nach irgendeinem der vorgehenden Ansprüche, **dadurch gekennzeichnet, dass** die Mittel (10) zur Kontrolle und zum Betreiben der besagten Steuermittel (9) und/oder der verschiedenen Testmittel (5, 6, 7, 8) durch eine Schnittstelle der Art Mensch-Maschine gebildet sind.

12. Vorrichtung nach den Ansprüchen 2 bis 6 und 10, **dadurch gekennzeichnet, dass** sie die Form eines Rahmens (27) annimmt, umfassend, einerseits, eine Kartenablage (28), vorgesehen, um die besagten elektronischen Karten (11, 13, I5, 19, 24) aufzunehmen, die insbesondere den Testmitteln (5, 6, 7, 8) entsprechen, und aufnehmend, andererseits, die besagte Testschnittstelle (4), wobei diese letztere (4) die Form eines abnehmbaren Gehäuses (29) annimmt, das mit Verbindungsmitteln (30) ausgestattet ist, die geeignet sind, um mit ergänzenden Verbindungsmitteln (31) zusammenzuwirken, die mit der besagten Kartenablage (28) verbunden sind.

13. Verfahren für die Determination von Mitteln, die geeignet sind, um eine Vorrichtung nach irgendeinem der Ansprüche 1 bis 12 zusammenzusetzen, und vorgesehen, um das Testen eines elektromechanischen Geräts (1), insbesondere einer elektronischen Karte, sicherzustellen, **dadurch gekennzeichnet, dass**:
- über Datenerfassungsmittel eine Datenerfassung von Informationen betreffend die mechanischen, topologischen und/oder elektronischen Eigenschaften des besagten elektromechanischen Geräts erlaubt wird;
- über Mittel zur Speicherung eine Speicherung dieser Informationen in einem Speicher gesichert wird;
- in Abhängigkeit von den gespeicherten, für das besagte elektromechanische Gerät kennzeichnenden Informationen und unter einer Mehrheit von Testszenarien, die in Speichermitteln enthalten sind, eine Auswahl zumindest eines Testszenarios ausgeführt wird, das geeignet ist, um auf das besagte elektromechanische Gerät anwendbar zu sein;
- einem jeden ausgewählten Testszenario die gesamten materiellen Ressourcen zugeordnet werden, die für die Umsetzung dieser Testszenarien notwendig sind;
- über Anzeigemittel eine Anzeige des gewählten Testszenarios oder der gewählten Testszenarien und/oder der materiellen Ressourcen gesichert wird, die für die Umsetzung dieser letzteren notwendig sind;
- für zumindest eines von diesen Testszenarien, einerseits, zumindest eine Testerarchitektur, integrierend die besagten notwendigen materiellen Ressourcen und entsprechend dem besagten Testszenario, und, andererseits, zumindest eine Gesamtheit von Testinstruktionen, vorgesehen, um durch diesen Tester auf das besagte elektromechanische Gerät angewendet zu werden, definiert werden, wobei die Architektur von diesem Tester sowie die Gesamtheit von Instruktionen geeignet seien, um dieses Testszenario oder diese Testszenarien umzusetzen, und ein Testermodell bilden, wobei das besagte Verfahren zumindest teilweise durch eine Software umgesetzt wird.

14. Verfahren nach Anspruch 13, **dadurch gekennzeichnet, dass**:
- wenn die Anzeige des ausgewählten Testszenarios oder der ausgewählten Testszenarien und/oder der entsprechenden materiellen Ressourcen sichergestellt wird, in Abhängigkeit von diesen letzteren und vermittels Auswahlmittel die Auswahl von zumindest einem von diesen Testszenarien erlaubt wird;
- anschließend, in Abhängigkeit von dem gewählten Testszenario oder von den gewählten Testszenarien, einerseits, zumindest eine Testerarchitektur, integrierend die besagten notwendigen, dem gewählten Testszenario entsprechenden materiellen Ressourcen, und, andererseits, zumindest eine Gesamtheit von Testinstruktionen, vorgesehen, um durch diesen Tester auf das besagte elektromechanische Gerät angewendet zu werden, definiert wird.

15. Verfahren nach irgendeinem der Ansprüche 13 oder 14, **dadurch gekennzeichnet, dass** anhand der Informationen, die den mechanischen und/oder elektronischen Eigenschaften des besagten elektromechanischen Geräts entsprechen, ein funktionales Modell dieses letzteren definiert wird, das in einer Aufteilung von diesem in wenigstens eine Gesamtheit von zusammengeschalteten Funktionsblöcken besteht.

16. Verfahren nach Anspruch 15, **dadurch gekennzeichnet, dass** für jeden Funktionsblock, einerseits, zumindest eine Gesamtheit von Testinstruktionen, geeignet, um auf diesen Funktionsblock anwendbar zu sein, und, andererseits, zumindest eine Testerarchitektur, geeignet, um das Testen eines solchen Funktionsblocks zu sichern, determiniert wird.

17. Verfahren nach irgendeinem der Ansprüche 13 bis 16, **dadurch gekennzeichnet, dass**, nachdem die Informationen betreffend die Eigenschaften des besagten elektromechanischen Geräts erfasst sind, die Erfassung von wenigstens einer Information betreffend eine qualimetrische Beanspruchung, die das Testszenario einhalten muss, erlaubt wird.
